# EUROPEAN PATENT APPLICATION

(11) **EP 4 572 147 A1**
(43) Date of publication of application: **18.06.2025**
(21) Application number: 24213134.0
(22) Date of filing: 15.11.2024
(51) Int. Cl.: H03K 19/17756, G06F 13/12, G06K 15/00

(54) **ELECTRONIC APPARATUS AND DATA STORAGE METHOD CAPABLE OF REDUCING THE NUMBER OF STORAGE PORTIONS CONNECTABLE TO LOGIC CIRCUIT**

(30) Priority: 15.12.2023 JP 2023211987
(71) Applicant: KYOCERA Document Solutions Inc., Osaka-shi, Osaka, 540-8585 (JP)
(72) Inventor: Shiomi, Ryo, Osaka-shi, 540-8585 (JP); Yokota, Hiroshi, Osaka-shi, 540-8585 (JP); Shibata, Yukio, Osaka-shi, 540-8585 (JP); Tanaka, Toshihiko, Osaka-shi, 540-8585 (JP); Isono, Tomoki, Osaka-shi, 540-8585 (JP)
(74) Representative: Plougmann Vingtoft a/s

(57) **Abstract**

An electronic apparatus (100) includes a logic circuit (63), a plurality of first storage portions (64A), a switching portion (65), and a storage processing portion (51B). The internal configuration of the logic circuit (63) is reconfigurable based on configuration data corresponding to one or more functions. The plurality of first storage portions (64A) separately store the configuration data. The switching portion (65) switches the first storage portion (64A) connected to the logic circuit (63). The storage processing portion (51B) stores, in a first storage portion (64A) not connected to the logic circuit (63) among the first storage portions (64A), the configuration data acquired from a second storage portion (54), instead of the configuration data stored in the first storage portion (64A).

## Description

### BACKGROUND

The present disclosure relates to an electronic apparatus and a data storage method.

There is known an electronic apparatus including a logic circuit, such as a field programmable gate array (FPGA), whose internal logic configuration can be reconfigured so as to enable implementation of one or more functions by reading configuration data corresponding to the one or more functions. Further, an electronic apparatus including a plurality of storage portions which separately store a plurality of items of the configuration data and capable of switching a connection target that is connected to the logic circuit between the plurality of storage portions is known as a related art.

### SUMMARY

An electronic apparatus according to an aspect of the present disclosure includes a logic circuit, a plurality of first storage portions, a switching portion, an acquisition processing portion, and a storage processing portion. The internal configuration of the logic circuit is reconfigurable based on configuration data corresponding to one or more functions. The plurality of first storage portions are provided so as to be connectable to the logic circuit and separately store a plurality of items of the configuration data having different corresponding functions or combinations of functions. The switching portion can switch a connection target connected to the logic circuit between the plurality of first storage portions. The acquisition processing portion acquires the configuration data from a second storage portion different from the first storage portions. The storage processing portion stores, in a first storage portion not connected to the logic circuit among the first storage portions, the configuration data acquired by the acquisition processing portion, instead of the configuration data stored in the first storage portion.

A data storage method according to another aspect of the present disclosure is executed by an electronic apparatus including a logic circuit whose internal configuration is reconfigurable based on configuration data corresponding to one or more functions, a plurality of first storage portions provided so as to be connectable to the logic circuit and configured to separately store a plurality of items of the configuration data having different corresponding functions or combinations of functions, and a switching portion capable of switching a connection target connected to the logic circuit between the plurality of first storage portions, and includes an acquisition step and a storage step. In the acquisition step, the configuration data is acquired from a second storage portion different from the first storage portions. In the storage step, the configuration data acquired by the acquisition processing portion is stored in a first storage portion not connected to the logic circuit among the first storage portions, instead of the configuration data stored in the first storage portion.

This Summary is provided to introduce a selection of concepts in a simplified form that are further described below in the Detailed Description with reference where appropriate to the accompanying drawings. This Summary is not intended to identify key features or essential features of the claimed subject matter, nor is it intended to be used to limit the scope of the claimed subject matter. Furthermore, the claimed subject matter is not limited to implementations that solve any or all disadvantages noted in any part of this disclosure.

### BRIEF DESCRIPTION OF THE DRAWINGS

FIG. 1 shows a configuration of an image forming apparatus according to an embodiment of the present disclosure.
FIG. 2 is a diagram showing a configuration of an image forming portion of the image forming apparatus according to the embodiment of the present disclosure.
FIG. 3 is a diagram showing configurations of a first control portion and a second control portion of the image forming apparatus according to the embodiment of the present disclosure.
FIG. 4 is a flowchart showing an example of logic circuit reconfiguration processing executed in the image forming apparatus according to the embodiment of the present disclosure.

### DETAILED DESCRIPTION

An embodiment of the present disclosure will be described below with reference to the accompanying drawings. It is noted that the following embodiment is an example of embodying the present disclosure and does not limit the technical scope of the present disclosure.

### [Configuration of Image Forming Apparatus 100]

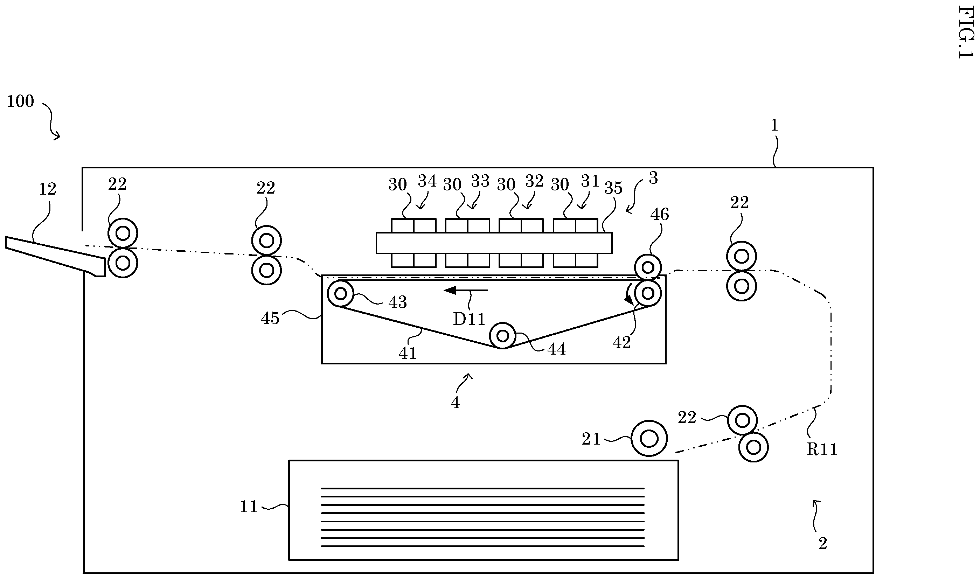

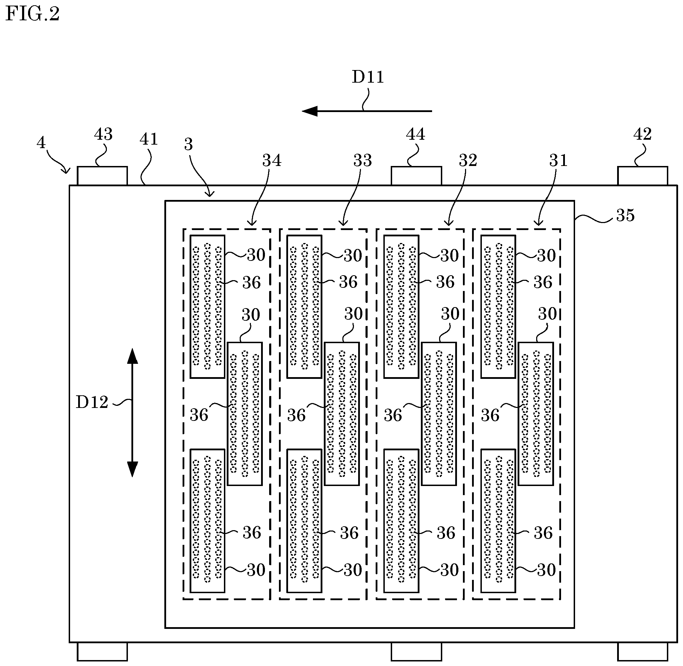

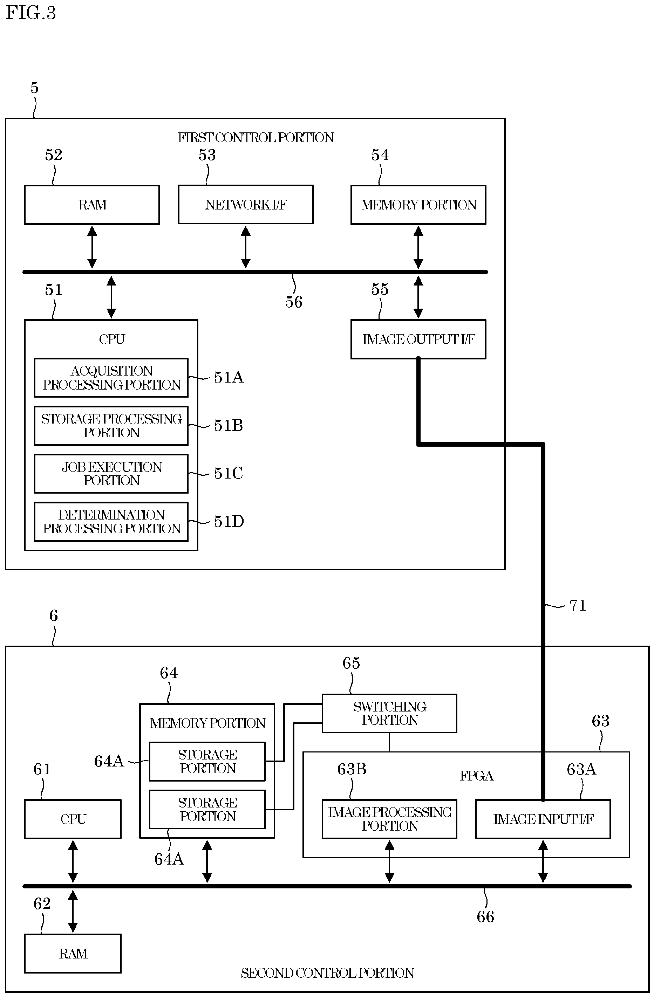

First, a configuration of an image forming apparatus 100 according to an embodiment of the present disclosure will be described with reference to FIG. 1 to FIG. 3. Here, FIG. 1 is a cross-sectional view showing a configuration of the image forming apparatus 100. In addition, FIG. 2 is a plan view showing configurations of an image forming portion 3 and a conveying unit 4. In addition, FIG. 3 is a block diagram showing configurations of a first control portion 5 and a second control portion 6. It is noted that a sheet conveying path R11 is indicated by a dash-dot-dot-dash line in FIG. 1.

The image forming apparatus 100 is a printer that can form an image on a sheet using an inkjet method. The image forming apparatus 100 is an example of the electronic apparatus of the present disclosure. It is noted that the present disclosure can be applied to electronic apparatuses such as scanners, facsimile machines, copiers, multifunction peripherals, personal computers, televisions, air conditioners, refrigerators, microwave ovens, and washing machines.

As shown in FIG. 1 to FIG. 3, the image forming apparatus 100 includes a housing 1, a sheet conveying portion 2, an image forming portion 3, a conveying unit 4, a first control portion 5, and a second control portion 6.

The housing 1 houses the constituent elements of the image forming apparatus 100. In the housing 1, a sheet feed cassette 11 is detachably provided. The sheet feed cassette 11 contains sheets on which images are formed. A sheet discharge tray 12 is provided on an outer surface of the housing 1. Sheets on which images have been formed by the image forming portion 3 are discharged to the sheet discharge tray 12. Inside the housing 1, the sheets contained in the sheet feed cassette 11 are conveyed along a sheet conveying path R11 (see FIG. 1) that leads to the sheet discharge tray 12 via an image forming position of the image forming portion 3.

The sheet conveying portion 2 conveys the sheets contained in the sheet feed cassette 11 along the sheet conveying path R11 (see FIG. 1). As shown in FIG. 1, the sheet conveying portion 2 includes a pickup roller 21 and a plurality of conveying rollers 22. The pickup roller 21 takes out the uppermost sheet of the sheet stack contained in the sheet feed cassette 11 and feeds the sheet to the sheet conveying path R11. The plurality of conveying rollers 22 are provided along the sheet conveying path R11. The conveying rollers 22 each convey the sheet along the sheet conveying path R11. The conveying rollers 22 each convey the sheet in a conveying direction D11 (see FIG. 1) from the sheet feed cassette 11 to the sheet discharge tray 12.

The image forming portion 3 forms an image based on image data on the sheet supplied from the sheet conveying portion 2. As shown in FIG. 1, the image forming portion 3 includes line heads 31 to 34 and a head frame 35.

As shown in FIG. 2, each of the line heads 31 to 34 is long in a width direction D12 orthogonal to the conveying direction D11. Specifically, the line heads 31 to 34 each have a length in the width direction D12 corresponding to the width of the maximum size sheet among the sheets that can be contained in the sheet feed cassette 11. The line heads 31 to 34 are provided at regular intervals along the conveying direction D11.

As shown in FIG. 2, the line heads 31 to 34 each include a plurality of print heads 30. The print heads 30 each eject ink toward the sheet conveyed by the conveying unit 4. Specifically, a large number of nozzles 36 (see FIG. 2) used for the ejection of the ink are provided on the surface of the print head 30 facing the sheet. The print heads 30 provided in the line head 31 each eject black ink. The print heads 30 provided in the line head 32 each eject cyan ink. The print heads 30 provided in the line head 33 each eject magenta ink. The print heads 30 provided in the line head 34 each eject yellow ink.

In the present embodiment, the line head 31 has three print heads 30 arranged in a staggered manner along the width direction D12. Similarly to the line head 31, each of the other line heads 32 to 34 also has three print heads 30 arranged in a staggered manner along the width direction D12. It is noted that FIG. 2 shows the image forming portion 3 as viewed from the top of FIG. 1.

The head frame 35 supports the line heads 31 to 34. The head frame 35 is supported by the housing 1. It is noted that the number of line heads provided in the image forming portion 3 may be one or more. In addition, the number of print heads 30 provided in each of the line heads 31 to 34 is not limited to three.

As shown in FIG. 1, the conveying unit 4 is disposed below the line heads 31 to 34. The conveying unit 4 conveys the sheet while having the sheet face the print heads 30. For example, each time the print heads 30 eject ink, the conveying unit 4 conveys the sheet by a predetermined conveying amount. In addition, the conveying unit 4 stops conveying the sheet while the print heads 30 are ejecting ink. As shown in FIG. 1, the conveying unit 4 includes a conveying belt 41 on which the sheet is placed, a first tension roller 42, a second tension roller 43, and a third tension roller 44 which tension the conveying belt 41, and a conveying frame 45 that supports them. It is noted that the gap between the conveying belt 41 and the print heads 30 is adjusted so that the gap between the surface of the sheet and the print heads 30 during image formation is a predetermined distance (for example, 1 mm).

The first tension roller 42 is driven to rotate by rotational drive force supplied by a motor (not shown). Thus, the conveying belt 41 rotates in a direction in which the sheet can be conveyed in the conveying direction D11 (see FIG. 1). It is noted that the conveying unit 4 is also provided with a suction unit (not shown) that sucks air from a large number of through holes formed in the conveying belt 41 in order to attract the sheet to the conveying belt 41. In addition, a pressure roller 46 is provided above the first tension roller 42 to convey the sheet while pressing the sheet against the conveying belt 41.

The first control portion 5 performs overall control of the image forming apparatus 100. As shown in FIG. 3, the first control portion 5 includes a CPU 51, a RAM 52, a network I/F 53, a memory portion 54, and an image output I/F 55. In the first control portion 5, the CPU 51, the RAM 52, the network I/F 53, the memory portion 54, and the image output I/F 55 are connected so as to be able to communicate with each other by a bus 56 shown in FIG. 3.

The CPU 51 is a processor that executes various types of arithmetic processing. The CPU 51 performs overall control of the image forming apparatus 100 by executing a control program stored in a ROM (not shown) provided in the first control portion 5.

The RAM 52 is a volatile storage device. The CPU 51 uses the RAM 52 as a temporary storage memory (work area) for various processes executed by the CPU 51.

The network I/F 53 is an interface that communicatively connects the image forming apparatus 100 to a communication apparatus external to the image forming apparatus 100.

The memory portion 54 is a nonvolatile storage device. For example, the memory portion 54 is a nonvolatile memory such as a flash memory. The memory portion 54 has a larger storage capacity than the memory portion 64 (see FIG. 3) provided in the second control portion 6. It is noted that the memory portion 54 may be a solid state drive (SSD) or a hard disk drive (HDD).

The image output I/F 55 is an interface that communicatively connects the first control portion 5 to the second control portion 6 via a data transmission path 71 (see FIG. 3). The data transmission path 71 is a serial transmission path. The data transmission path 71 is used for transmission of image data from the first control portion 5 to the second control portion 6. For example, the image output I/F 55 converts the image data to be transmitted into a serial signal in accordance with a predetermined interface standard such as FPD-Link or V-by-One, and outputs the converted serial signal to the data transmission path 71.

The second control portion 6 controls the operations of the sheet conveying portion 2, the image forming portion 3, and the conveying unit 4. As shown in FIG. 3, the second control portion 6 includes a CPU 61, a RAM 62, a field programmable gate array (FPGA) 63, a memory portion 64, and a switching portion 65. In the second control portion 6, the CPU 61, the RAM 62, the FPGA 63, and the memory portion 64 are connected so as to be able to communicate with each other by a bus 66 shown in FIG. 3.

The CPU 61 is a processor that executes various types of arithmetic processing. The CPU 61 controls the operations of the sheet conveying portion 2, the image forming portion 3, and the conveying unit 4 by executing a control program stored in a ROM (not shown) provided in the second control portion 6.

In the image forming apparatus 100, inter-CPU communication is performed between the CPU 51 and the CPU 61. The inter-CPU communication is data communication at a lower speed than data communication using the data transmission path 71.

The RAM 62 is a volatile storage device. The CPU 61 uses the RAM 62 as a temporary storage memory (work area) for various processes executed by the CPU 61.

The FPGA 63 is an electronic circuit capable of reconfiguring an internal logic configuration so that one or more functions can be realized by reading configuration data corresponding to the one or more functions. The FPGA 63 is an example of the logic circuit of the present disclosure. It is noted that the logic circuit in the present disclosure is not limited to the FPGA, and may be any electronic circuit as long as the internal logic configuration can be reconfigured based on the configuration data.

The FPGA 63 is used for image processing on image data. Specifically, as shown in FIG. 3, the FPGA 63 includes an image input I/F 63A and an image processing portion 63B. The FPGA 63 functions as the image input I/F 63A and the image processing portion 63B by reading the configuration data stored in a storage portion 64A (see FIG. 3) connected to the FPGA 63.

The image input I/F 63A is an interface that communicatively connects the first control portion 5 to the second control portion 6 via the data transmission path 71. The image input I/F 63A converts a serial signal input from the data transmission path 71 into image data in accordance with the interface standard, and outputs the converted image data.

The image processing portion 63B executes image processing on the image data transmitted from the first control portion 5. The image processing portion 63B executes image processing corresponding to the configuration data read by the FPGA 63.

An electronic apparatus including a plurality of storage portions that separately store a plurality of items of the configuration data and capable of switching a connection target that is connected to the FPGA 63 between the plurality of storage portions is known as a related art.

However, in the electronic apparatus according to the related art described above, the greater the number of functions to be realized by the FPGA 63, the greater the number of storage portions that can be connected to the FPGA 63. Therefore, the configuration of the second control portion 6 becomes complicated.

On the other hand, in the image forming apparatus 100 according to the embodiment of the present disclosure, as will be described below, the number of the storage portions provided so as to be connectable to the FPGA 63 can be reduced.

In the image forming apparatus 100, a plurality of items of the configuration data having different corresponding functions or combinations of functions are stored in the memory portion 54 of the first control portion 5. For example, first configuration data, second configuration data, and third configuration data are stored in the memory portion 54.

The first configuration data enables the FPGA 63 to function as the image input I/F 63A and the image processing portion 63B that executes first image processing. For example, the first image processing is image processing corresponding to a first image forming mode in which image data is printed in color with high image quality.

The second configuration data enables the FPGA 63 to function as the image input I/F 63A and the image processing portion 63B that executes second image processing. For example, the second image processing is image processing corresponding to a second image forming mode in which image data is printed in color at high speed. The second image forming mode is an image forming mode with faster printing speed and lower print quality than the first image forming mode.

The third configuration data enables the FPGA 63 to function as the image input I/F 63A and the image processing portion 63B that executes third image processing. For example, the third image processing is image processing corresponding to a third image forming mode in which image data is printed in monochrome.

It is noted that the number of items of the configuration data stored in the memory portion 54 may be four or more. In addition, the configuration data stored in the memory portion 54 may be updated by update data acquired from a server external to the image forming apparatus 100.

The memory portion 64 separately stores a plurality of items of the configuration data having different corresponding functions or combinations of functions. As shown in FIG. 3, the memory portion 64 includes two storage portions 64A. The two storage portions 64A are an example of the plurality of first storage portions of the present disclosure. It is noted that the memory portion 64 may include three or more storage portions 64A.

Each of the storage portions 64A is a nonvolatile storage device. For example, each of the storage portions 64A is a flash memory. Each of the storage portions 64A is provided so as to be connectable to the FPGA 63. Each of the storage portions 64A stores one of the items of the configuration data stored in the memory portion 54 of the first control portion 5.

It is noted that the memory portion 64 may be one or more storage devices. In this case, each of the storage portions 64A may be a storage area set in the memory portion 64.

The switching portion 65 can switch the connection target that is connected to the FPGA 63 between the two storage portions 64A. For example, the switching portion 65 is a multiplexer capable of switching the connection target. It is noted that the switching portion 65 may be a mechanical switch or a relay.

As shown in FIG. 3, the CPU 51 of the first control portion 5 includes an acquisition processing portion 51A, a storage processing portion 51B, a job execution portion 51C, and a determination processing portion 51D.

Specifically, the ROM of the first control portion 5 stores in advance operation control programs for causing the CPU 51 to function as the respective portions described above. By executing the operation control programs stored in the ROM, the CPU 51 functions as the respective portions described above.

It is noted that the operation control programs may be recorded on a computer-readable recording medium such as a CD, a DVD, or a flash memory, and may be read from the recording medium and stored in a storage device such as the memory portion 54. In addition, some or all of the above-mentioned functional portions may be composed of an electronic circuit such as an integrated circuit (ASIC). In addition, the operation control programs may be programs for causing a plurality of processors to function as the functional portions described above.

The acquisition processing portion 51A acquires the configuration data from the memory portion 54 (an example of the second storage portion of the present disclosure).

The storage processing portion 51B stores the configuration data acquired by the acquisition processing portion 51A in a non-connected storage portion, which is not connected to the FPGA 63, of the two storage portions 64A, instead of the configuration data stored in the non-connected storage portion.

For example, the storage processing portion 51B transmits the configuration data acquired by the acquisition processing portion 51A to the second control portion 6 using the data transmission path 71. In addition, the storage processing portion 51B instructs the CPU 61 of the second control portion 6 to store the configuration data transmitted from the first control portion 5 in the non-connected storage portion.

The job execution portion 51C executes an image forming job for forming an image based on image data.

For example, an image forming job including designation information that designates one of the first image forming mode, the second image forming mode, and the third image forming mode is input to the image forming apparatus 100 from an external information processing apparatus.

When the image forming job is input from the external information processing apparatus, the job execution portion 51C executes the input image forming job in accordance with the designated image forming mode.

Here, when the image forming job is executed, the FPGA 63 is reconfigured so as to be able to execute image processing corresponding to the image forming mode, using the configuration data corresponding to the image forming mode of the image forming job to be executed.

Specifically, when the configuration data corresponding to the image forming mode of the image forming job to be executed is stored in the non-connected storage portion, the CPU 51 uses the switching portion 65 to switch the connection target and restarts the FPGA 63.

In addition, when the configuration data corresponding to the image forming mode of the image forming job to be executed is not stored in any of the storage portions 64A, the acquisition processing portion 51A acquires the configuration data corresponding to the image forming mode of the image forming job to be executed from the memory portion 54. In addition, the storage processing portion 51B stores the configuration data acquired by the acquisition processing portion 51A in the non-connected storage portion, instead of the configuration data stored in the non-connected storage portion. Then, the CPU 51 switches the connection target using the switching portion 65, and restarts the FPGA 63.

It is noted that the FPGA 63 instructed to restart by the CPU 51 first executes a reset process of resetting itself, then reads the configuration data from the connection target, and then executes a configuration process of reconfiguring the internal logic configuration based on the read data.

When an image forming job in the standby state exists during the execution of the image forming job, the determination processing portion 51D determines whether or not the configuration data corresponding to the image forming mode of the image forming job in the standby state is stored in any of the plurality of storage portions 64A.

For example, when an image forming job in the standby state exists during the execution of the image forming job, the determination processing portion 51D determines whether or not the image forming mode of a first image forming job being executed is the same as the image forming mode of a second image forming job to be executed next.

Here, when the image forming mode of the first image forming job is the same as the image forming mode of the second image forming job, the determination processing portion 51D determines that the configuration data corresponding to the image forming mode of the second image forming job is stored in the storage portion 64A connected to the FPGA 63.

In addition, when the image forming mode of the first image forming job is not the same as the image forming mode of the second image forming job, the determination processing portion 51D determines whether or not the image forming mode of a third image forming job executed immediately before the first image forming job is the same as the image forming mode of the second image forming job. When the image forming mode of the third image forming job is the same as the image forming mode of the second image forming job, the determination processing portion 51D determines that the configuration data corresponding to the image forming mode of the second image forming job is stored in the non-connected storage portion. In addition, when the image forming mode of the third image forming job is not the same as the image forming mode of the second image forming job, the determination processing portion 51D determines that the configuration data corresponding to the image forming mode of the second image forming job is not stored in any of the plurality of storage portions 64A.

Here, when the determination processing portion 51D determines that the configuration data corresponding to the image forming mode of the image forming job in the standby state is not stored in any of the plurality of storage portions 64A, the acquisition processing portion 51A acquires the configuration data corresponding to the image forming mode of the image forming job in the standby state from the memory portion 54 during the execution of the image forming job.

For example, the acquisition processing portion 51A acquires the configuration data corresponding to the image forming mode of the second image forming job from the memory portion 54 during the execution of the first image forming job.

In addition, the storage processing portion 51B stores the configuration data acquired by the acquisition processing portion 51A in the non-connected storage portion during the execution of the image forming job.

For example, the storage processing portion 51B stores the configuration data corresponding to the image forming mode of the second image forming job acquired by the acquisition processing portion 51A in the non-connected storage portion during the execution of the first image forming job.

Here, the configuration data corresponding to the image forming mode of the image forming job in the standby state is transmitted from the first control portion 5 to the second control portion 6 using the data transmission path 71 during a non-transmission period in which image data is not transmitted using the data transmission path 71 during the execution of the image forming job. Thus, the configuration data can be transmitted from the first control portion 5 to the second control portion 6 during the execution of the image forming job without interfering with the execution of the image forming job.

### [Logic Circuit Reconfiguration Processing]

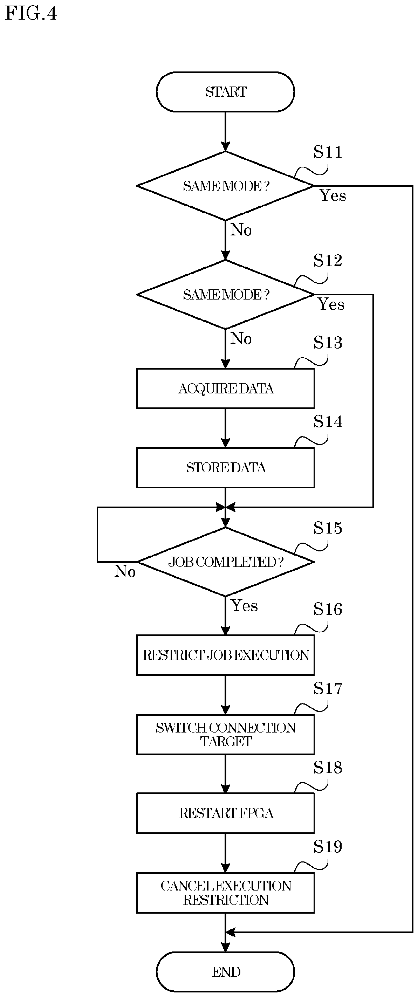

The data storage method of the present disclosure will be described below with reference to FIG. 4, along with an example of the procedure of the logic circuit reconfiguration processing executed by the CPU 51 of the first control portion 5 in the image forming apparatus 100. Here, steps S11, S12, ... represent the numbers of the processing procedure (steps) executed by the CPU 51. It is noted that the logic circuit reconfiguration processing is executed when an image forming job in the standby state exists during the execution of the image forming job. That is, the logic circuit reconfiguration processing is executed when the first image forming job and the second image forming job exist.

### <Step S11 >

First, in step S11, the CPU 51 determines whether or not the image forming mode of the first image forming job is the same as the image forming mode of the second image forming job.

Here, when the CPU 51 determines that the image forming mode of the first image forming job is the same as the image forming mode of the second image forming job (Yes in S11), the CPU 51 ends the logic circuit reconfiguration processing. In addition, when the image forming mode of the first image forming job is not the same as the image forming mode of the second image forming job (No in S11), the CPU 51 shifts the processing to step S12.

### <Step S12>

In step S12, the CPU 51 determines whether or not the image forming mode of the third image forming job executed immediately before the first image forming job is the same as the image forming mode of the second image forming job. Here, the processes of step S11 and step S12 are executed by the determination processing portion 51D.

Here, when the CPU 51 determines that the image forming mode of the third image forming job is the same as the image forming mode of the second image forming job (Yes in S12), the CPU 51 shifts the processing to step S15. In addition, when the image forming mode of the third image forming job is not the same as the image forming mode of the second image forming job (No in S12), the CPU 51 shifts the processing to step S13.

### <Step S13>

In step S13, the CPU 51 acquires the configuration data corresponding to the image forming mode of the second image forming job from the memory portion 54 during the execution of the first image forming job. Here, the process of step S13 is an example of the acquisition step of the present disclosure, and is executed by the acquisition processing portion 51A.

### <Step S14>

In step S14, the CPU 51 stores the configuration data acquired by the process of step S13 in the non-connected storage portion during the execution of the first image forming job. Here, the process of step S14 is an example of the storage step of the present disclosure, and is executed by the storage processing portion 51B.

Specifically, the CPU 51 transmits the configuration data acquired by the acquisition processing portion 51A to the second control portion 6 using the data transmission path 71 during a sheet-interval time from the end of transmission of the image data to be printed on a sheet to the start of transmission of the image data to be printed on the next sheet. In addition, the CPU 51 instructs the CPU 61 of the second control portion 6 to store the configuration data transmitted from the first control portion 5 in the non-connected storage portion.

### <Step S15>

In step S15, the CPU 51 determines whether or not the first image forming job has been completed.

Here, when the CPU 51 determines that the first image forming job has been completed (Yes in S15), the CPU51 shifts the processing to step S16. In addition, when the first image forming job has not been completed (No in S15), the CPU 51 waits for the first image forming job to be completed in step S15.

### <Step S16>

In step S16, the CPU 51 restricts the execution of the image forming job by the job execution portion 51C.

### <Step S17>

In step S17, the CPU 51 uses the switching portion 65 to switch the connection target. Thus, the FPGA 63 is connected to the storage portion 64A in which the configuration data corresponding to the image forming mode of the second image forming job is stored.

### <Step S18>

In step S18, the CPU 51 restarts the FPGA 63. Thus, the FPGA 63 is reconfigured so that the FPGA 63 corresponds to the image forming mode of the second image forming job.

### <Step S19>

In step S19, the CPU 51 cancels the restriction of the execution of the image forming job by the job execution portion 51C. Thus, the execution of the second image forming job is started by the job execution portion 51C.

Accordingly, in the image forming apparatus 100, the configuration data acquired from the memory portion 54 is stored in the non-connected storage portion, instead of the configuration data stored in the non-connected storage portion. This makes it possible to increase the number of functions to be realized by the FPGA 63 without increasing the number of storage portions 64A provided so as to be connectable to the FPGA 63. Therefore, the number of storage portions 64A provided so as to be connectable to the FPGA 63 can be reduced.

In addition, in the image forming apparatus 100, when the configuration data corresponding to the image forming mode of the second image forming job is not stored in any of the storage portions 64A, the configuration data corresponding to the image forming mode of the second image forming job is stored in the non-connected storage portion during the execution of the first image forming job. This makes it possible to reduce the waiting time of the user who waits for the start of the execution of the second image forming job, compared with the configuration in which the configuration data corresponding to the image forming mode of the second image forming job is stored in one of the storage portions 64A after the first image forming job is completed.

In addition, in the image forming apparatus 100, the configuration data corresponding to the image forming mode of the second image forming job is transmitted from the first control portion 5 to the second control portion 6 using the data transmission path 71 during the non-transmission period during the execution of the first image forming job. Thus, for example, the configuration data corresponding to the image forming mode of the second image forming job can be transmitted to the second control portion 6 faster than in the configuration in which the configuration data is transmitted by the inter-CPU communication executed between the CPU 51 and the CPU 61 during the execution of the first image forming job.

It is noted that the configuration data may be damaged during the transfer of the configuration data. When the FPGA 63 is reconfigured based on the damaged configuration data, the operation of the image input I/F 63A may be disturbed, and data transmission from the first control portion 5 to the second control portion 6 using the data transmission path 71 may become impossible.

In this case, the CPU 51 may use the switching portion 65 to switch the connection target and restart the FPGA 63. This makes it possible to restore the function of the image input I/F 63A as long as the configuration data stored in the non-connected storage portion is not damaged.

In addition, when the function of the image input I/F 63A cannot be restored even by restarting the FPGA 63, the CPU 51 may transmit the configuration data from the first control portion 5 to the second control portion 6 through the inter-CPU communication.

### [Appendixes of Invention]

The following are appendixes to the overview of the invention extracted from the above embodiment. It is noted that the structures and processing functions to be described in the following appendixes can be selected and combined arbitrarily.

### <Appendix 1 >

An electronic apparatus comprising: a logic circuit whose internal configuration is reconfigurable based on configuration data corresponding to one or more functions; a plurality of first storage portions provided so as to be connectable to the logic circuit and configured to separately store a plurality of items of the configuration data having different corresponding functions or combinations of functions; a switching portion capable of switching a connection target connected to the logic circuit between the plurality of first storage portions; an acquisition processing portion configured to acquire the configuration data from a second storage portion different from the first storage portions; and a storage processing portion configured to store, in a first storage portion not connected to the logic circuit among the first storage portions, the configuration data acquired by the acquisition processing portion, instead of the configuration data stored in the first storage portion.

### <Appendix 2>

The electronic apparatus according to Appendix 1, further comprising a job execution portion configured to execute an image forming job for forming an image based on image data, wherein when the image forming job is executed, the logic circuit is reconfigured, using the configuration data corresponding to an image forming mode of the image forming job to be executed, so as to be able to execute image processing corresponding to the image forming mode, the electronic apparatus comprises a determination processing portion configured to determine, when an image forming job in a standby state exists during execution of the image forming job, whether or not the configuration data corresponding to the image forming mode of the image forming job in the standby state is stored in any of the plurality of first storage portions, when the determination processing portion determines that the configuration data corresponding to the image forming mode of the image forming job in the standby state is not stored in any of the plurality of first storage portions, the acquisition processing portion acquires the configuration data corresponding to the image forming mode of the image forming job in the standby state from the second storage portion during execution of the image forming job, and the storage processing portion stores the configuration data acquired by the acquisition processing portion in the first storage portion during execution of the image forming job.

### <Appendix 3>

The electronic apparatus according to Appendix 2, further comprising: a first control portion including the second storage portion; a second control portion including the logic circuit, the plurality of first storage portions, and the switching portion; and a data transmission path used for transmission of the image data from the first control portion to the second control portion, wherein the configuration data corresponding to the image forming mode of the image forming job in the standby state is transmitted from the first control portion to the second control portion, using the data transmission path, during a non-transmission period in which the image data is not transmitted using the data transmission path during execution of the image forming job.

### <Appendix 4>

A data storage method executed by an electronic apparatus including a logic circuit whose internal configuration is reconfigurable based on configuration data corresponding to one or more functions, a plurality of first storage portions provided so as to be connectable to the logic circuit and configured to separately store a plurality of items of the configuration data having different corresponding functions or combinations of functions, and a switching portion capable of switching a connection target connected to the logic circuit between the plurality of first storage portions, the data storage method comprising: an acquisition step of acquiring the configuration data from a second storage portion different from the first storage portions; and a storage step of storing, in a first storage portion not connected to the logic circuit among the first storage portions, the configuration data acquired by the acquisition step, instead of the configuration data stored in the first storage portion.

It is to be understood that the embodiments herein are illustrative and not restrictive, since the scope of the disclosure is defined by the appended claims rather than by the description preceding them, and all changes that fall within metes and bounds of the claims, or equivalence of such metes and bounds thereof are therefore intended to be embraced by the claims.

## Claims

1. An electronic apparatus (100) comprising:
a logic circuit (63) whose internal configuration is reconfigurable based on configuration data corresponding to one or more functions;
a plurality of first storage portions (64A) provided so as to be connectable to the logic circuit (63) and configured to separately store a plurality of items of the configuration data having different corresponding functions or combinations of functions;
a switching portion (65) capable of switching a connection target connected to the logic circuit (63) between the plurality of first storage portions (64A);
an acquisition processing portion (51A) configured to acquire the configuration data from a second storage portion (54) different from the first storage portions (64A); and
a storage processing portion (51B) configured to store, in a first storage portion (64A) not connected to the logic circuit (63) among the first storage portions (64A), the configuration data acquired by the acquisition processing portion (51A), instead of the configuration data stored in the first storage portion (64A).

2. The electronic apparatus (100) according to claim 1, further comprising:
a job execution portion (51C) configured to execute an image forming job for forming an image based on image data, wherein
when the image forming job is executed, the logic circuit (63) is reconfigured, using the configuration data corresponding to an image forming mode of the image forming job to be executed, so as to be able to execute image processing corresponding to the image forming mode,
the electronic apparatus (100) comprises a determination processing portion (51D) configured to determine, when an image forming job in a standby state exists during execution of the image forming job, whether or not the configuration data corresponding to the image forming mode of the image forming job in the standby state is stored in any of the plurality of first storage portions (64A),
when the determination processing portion (51D) determines that the configuration data corresponding to the image forming mode of the image forming job in the standby state is not stored in any of the plurality of first storage portions (64A), the acquisition processing portion (51A) acquires the configuration data corresponding to the image forming mode of the image forming job in the standby state from the second storage portion (54) during execution of the image forming job, and
the storage processing portion (51B) stores the configuration data acquired by the acquisition processing portion (51A) in the first storage portion (64A) during execution of the image forming job.

3. The electronic apparatus (100) according to claim 2, further comprising:
a first control portion (5) including the second storage portion (54);
a second control portion (6) including the logic circuit (63), the plurality of first storage portions (64A), and the switching portion (65); and
a data transmission path (71) used for transmission of the image data from the first control portion (5) to the second control portion (6), wherein
the configuration data corresponding to the image forming mode of the image forming job in the standby state is transmitted from the first control portion (5) to the second control portion (6), using the data transmission path (71), during a non-transmission period in which the image data is not transmitted using the data transmission path (71) during execution of the image forming job.

4. A data storage method executed by an electronic apparatus (100) including a logic circuit (63) whose internal configuration is reconfigurable based on configuration data corresponding to one or more functions, a plurality of first storage portions (64A) provided so as to be connectable to the logic circuit (63) and configured to separately store a plurality of items of the configuration data having different corresponding functions or combinations of functions, and a switching portion (65) capable of switching a connection target connected to the logic circuit (63) between the plurality of first storage portions (64A), the data storage method comprising:
an acquisition step of acquiring the configuration data from a second storage portion (54) different from the first storage portions (64A); and
a storage step of storing, in a first storage portion (64A) not connected to the logic circuit (63) among the first storage portions (64A), the configuration data acquired by the acquisition step, instead of the configuration data stored in the first storage portion (64A).
